# EUROPEAN PATENT SPECIFICATION

(11) **EP 3 528 365 B1**
(45) Date of publication and mention of the grant of the patent: **22.07.2020**
(21) Application number: 18000161.2
(22) Date of filing: 19.02.2018
(51) Int. Cl.: H02J 50/12

(54) **TURNER AND RECTIFIER APPARATUS FOR WIRELESS POWER TRANSFER RECEIVER**
WENDE- UND GLEICHRICHTERVORRICHTUNG FÜR DRAHTLOSEN STROMÜBERTRAGUNGSEMPFÄNGER
APPAREIL DE SYNTONISEUR ET DE REDRESSEUR POUR RÉCEPTEUR DE TRANSFERT DE PUISSANCE SANS FIL

(43) Date of publication of application: 21.08.2019
(73) Proprietor: Naptilus Technology Lab, S.L., 08008 Barcelona (ES)
(72) Inventor: Alarcon Cot, Eduardo José, 08008 Barcelona (ES); Abdelhameed, Mohamed, 08008 Barcelona (ES); Aibar Sala, Jordi, 08008 Barcelona (ES); Terradas Robledo, Rafael, 08008 Barcelona (ES)
(74) Representative: Maldonado Jordan, Julia

(56) References cited:
- WO-A2-2012/085119
- MINSHENG YANG ET AL: "Transferred Power Control for ICPT Pick-ups Utilizing Dynamically Switched Inductor*", ENERGY PROCEDIA, vol. 16, 1 January 2012 (2012-01-01), pages 1440-1447, XP028472351, ISSN: 1876-6102, DOI: 10.1016/J.EGYPRO.2012.01.227 [retrieved on 2012-03-17]
- SAAD MOHAMED ET AL: "A PLL control for self-tuning of parallel wireless power transfer receivers utilizing switch-mode gyrator emulated inductors", 2017 19TH EUROPEAN CONFERENCE ON POWER ELECTRONICS AND APPLICATIONS (EPE'17 ECCE EUROPE), JOINTLY OWNED IEEE-PELS AND EPE ASSOCIATION, 11 September 2017 (2017-09-11), XP033250559, DOI: 10.23919/EPE17ECCEEUROPE.2017.8099177 [retrieved on 2017-11-06]
- JAMES J ET AL: "A variable inductor based tuning method for ICPT pickups", POWER ENGINEERING CONFERENCE, 2005. IPEC 2005. THE 7TH INTERNATIONAL SINGAPORE 29-02 NOV. 2005, PISCATAWAY, NJ, USA,IEEE, PISCATAWAY, NJ, USA, 29 November 2005 (2005-11-29), page 1142, XP031330795, ISBN: 978-981-05-5702-7

## Description

### Field of the invention

The present invention relates to wireless power transfer and wireless power transfer receivers and, more specifically, to a tuner and bridgeless rectifier in a compact circuit structure.

### Technical background and related art

Magnetic resonance wireless power transfer (WPT) has become a reliable technology for contactless power delivery for a wide range of applications. The WPT spans a wide field of applications ranging from few milliwatts low-power sensors up to tens of kilowatts high-power electric vehicles. In WPT systems, a transmitting coils is energized by an alternating current producing a magnetic flux that is linked to one or more other receiving coils that are attached to either a stationary or moving load. In order to enhance the efficiency of WPT links while extending the power delivery distance, a resonating coils are created at the transmitter and receiver sides by compensating the coils using capacitive elements connected either in series or parallel with the corresponding coils. The transmitter and receiver resonant circuits must be tuned to the same frequency of operation in order to ensure a maximum power transmission at the highest possible efficiency.

A common problem in magnetic WPT systems is the stability and sensitivity issues when the transmitting and receiving resonant circuits are designed for high quality factor (Q) operation. It has been shown that the higher the quality factor, the higher the maximum power that could be delivered to the load. On the other hand, a high Q WPT receiver implicates high selective resonant characteristics that makes the resonant tank vulnerable to any small mismatch. The mismatch causes include, but are not limited to, frequency drifts, circuit parameter variations due to components tolerance or environmental effects, metallic or radiating proximity devices, and misalignment between coils. Any source of mismatch would deteriorate the performance of high Q WPT receivers and the power transfer capability is greatly degraded. To enable the employment of high Q resonant WPT receivers, the receivers has to be equipped by a device for compensating the potential effects of mismatch.

Solutions for this problem include adding a variable reactive element to the WPT receiver tank that could be used for tuning. This approach has been described in U.S. Pat. No. 8,093,758, where an inductor has been added to the receiver to tune or detune the resonant circuit dynamically according to the load conditions. However, this approach has been applied for the purpose of decreasing the losses of the receiver power converter at light loads. Moreover, a rectifying bridge is required. Another approach in U.S. Pat. No. 8,183,938 disclosed a variable reactance realized in one embodiment by a saturable core inductor where the inductance value is controlled by varying a bias current to control the output power level. However, the disclosed system is used to track the tuning condition of the system while a separated power circuit is required for rectification and regulation of the output power.

Another approach posed in U.S. Pat. No. 9,236,771 where a plurality of variable capacitors is coupled or decoupled from the resonant tank through a plurality of switches in order to alter the resonance frequency of the resonant tank. However, this approach requires a large number of capacitors and switches still with limited tuning capabilities.

Another example using an inductor emulating a variable reactive inductance could be found in the scientific publication "Transferred Power Control for ICPT Pick-ups Utilizing Dynamically Switched Inductor" (Energy procedia vol. 16, 1 January 2012) f

### Summary of the invention

This invention is meant to enable the employment of high Q resonant WPT receivers while an automatic tuning for the resonant circuit is achieved with one central inductor coupled between two switching networks whereas the rectification from alternating current to charge an output buffer is achieved using the same circuit. A compact circuit structure is configured to: sense the tuning condition of the WPT receiver tank and adaptively generate a time period synchronized with respect to the positive and negative cycles; couple the inductor with the resonant circuit to charge the inductor from the resonant voltage during a first portion of time; and couple the inductor between the resonant tank and the output energy buffer in order to rectify the energy from the resonant tank to the output buffer during a second time portion.

The invention also comprises a switch controlling circuit that senses one or more parameters from the receiver resonant circuit and respond by generating an adaptive time period accordingly; wait for the said time period and then switch one or more switches of the first switching network to couple to the receiver resonant circuit during a first time portion; and switch one or more switches of the second switching network to couple the central inductor between the receiver resonant circuit and the output buffer during a second time portion.

In another aspect, the invention discloses one of the preferred embodiments, wherein the receiver resonant circuit is coupled between a first node and a second node. An inductor coupled between a third node and a fourth node. A first switching network, comprises: a first switch coupled between the first node and the third node; and a second switch coupled between fourth node and the second node. A second switching network comprises: a first switch coupled between the fourth node and fifth node; and a second switch coupled between the third node and fifth node. An energy buffer network comprises at least one energy buffer element coupled between the fifth node and the second node. A switch controlling circuit configured to sense the voltage or current or both of the receiver resonant circuit and respond by closing one switch or more of the first and second switching network after an adaptive time period synchronized with their respective cycles of the receiver resonant voltage.

This aspect includes waiting for elapsing of the adaptive time period generated by the switch controlling circuit during the positive cycle of the resonant voltage, then the inductor is coupled between the first and the second node by closing the first and the second switches of the first switching network during a fixed or variable first time portion. In the said first time portion, the inductor charges from the receiver resonant voltage. Then, the second switch of the first switching network is opened and the first switch of the second switching network is closed to couple the inductor between the third and the fourth node during a fixed or variable second time portion. In the said second time portion, the output energy buffer is energized from the receiver resonant circuit and the inductor. This sequence is repeated during the negative cycle of the resonant voltage, where the first and second switches of the first switching network are closed to charge the inductor with a negative current, and then the first switch of the first switching network is opened and second switch of the second switching network is closed to energize the output energy buffer from the inductor during a second time portion.

In a further aspect of the invention, another embodiment of the invention is a receiver resonant circuit coupled between a first node and second node. An inductor coupled between a first node and a third node. A first switching network, comprises: a switch coupled between the third node and the second node. A second switching network, comprises: a first switch coupled between the third node and fourth node; and a second switch coupled between the third node and fifth node. An energy buffer network, comprises: a first energy buffer coupled between the fourth node and the second node; and a second energy buffer coupled between the second node and the fifth node. A switch controlling circuit configured to sense the voltage or current or both of the receiver resonant circuit and respond by closing one switch or more of the first and second switching network after an adaptive time period synchronized with their respective cycles of the receiver resonant voltage.

This aspect includes waiting for elapsing of the adaptive time period generated by the switch controlling circuit during the positive cycle of the resonant voltage, then the inductor is coupled between the first and the second node by closing the switch of the first switching network during a fixed or variable first time portion. In the said first time portion, the inductor charges from the receiver resonant voltage. Then, the switch of the first switching network is opened and the first switch of the second switching network is closed to couple the inductor between the third and the fourth node during a fixed or variable second time portion. In the said second time portion, the first energy buffer is energized from the receiver resonant circuit and the inductor. This sequence is repeated during the negative cycle of the resonant voltage, where the switch of the first switching network is closed to charge the inductor with a negative current, and then the switch of the first switching network is opened and second switch of the second switching network is closed to energize the second energy buffer from the receiver resonant voltage and the inductor during a second time portion. The invention may also broadly consist in any new parts, elements and features referred to herein, individually or collectively, in any or all combinations of said parts, elements or features.

### Brief description of the figures of the drawings

- Figure 1 shows a schematic diagram for one known embodiment of power flow control in WPT receivers.
- Figure 2 is a block diagram showing a WPT receiver connected to the tuner and rectifier device of the disclosure.
- Figure 3 is a schematic diagram of one embodiment showing of the disclosed tuner and rectifier device.
- Figure 4 is a schematic diagram showing another embodiment of a tuner and rectifier device.
- Figure 5 shows a block diagram of the control of one of the preferred embodiments.
- Figure 6 shows the resonant tank voltage and the corresponding current in the inductor of the embodiment in Figure 3 while showing the direct current voltage of the output buffer.
- Figure 7 shows a graph of the equivalent variable inductance versus the time-delay and the equivalent ac resistance versus the same time-delay.

### Description of preferred embodiments

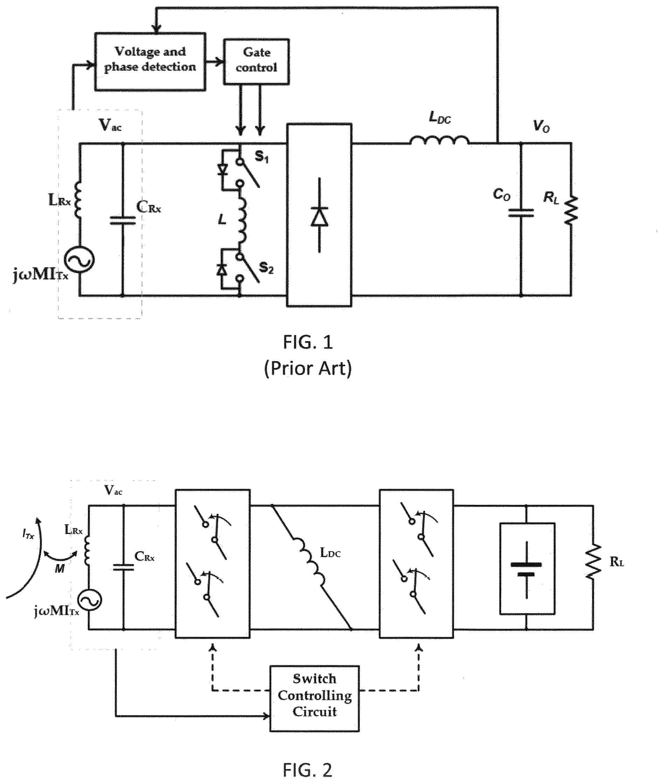

Referring to the drawings, the preferred embodiments of the invention are described in details. Figure 2 shows the block diagram of a WPT receiver coupled to a tuner and rectifier device which may be considered as a general embodiment for invention. In general, the WPT receiver comprises: a WPT receiver resonant tank coupled between a first node and a second node; a central inductor *L_{DC}* coupled between a third node and a fourth node; an energy buffer network coupled between a fifth node and a sixth node; a first switching network having two ports and the first port is coupled between the first and the second nodes, while the second port is coupled between the third and the fourth nodes; a second switching network having two ports and the first port is coupled between the third and the fourth nodes, while the second port is coupled between the fifth and the sixth nodes; and a switch controlling circuit that senses one or more parameters of the WPT receiver resonant tank and respond by controlling the switches of the first or the second switching networks.

The first switching network or the first switching network in Figure 2 may contain one or more switches. The central inductor *L_{DC}* having two terminals coupled between the first switching networks and the second switching networks, wherein the inductor *L_{DC}* may be coupled in to the terminals of the receiver resonant circuit or coupled to the terminals of the energy buffer network or coupled between the receiver resonant circuit and the energy buffer network.

In operation, the switch controlling circuit in Figure 2 may sense one or more parameters of the receiver resonant circuit to track the tuning condition of the receiver resonant circuit. The controller, in response to the tuning condition of the receiver resonant tank, may respond by closing one or more switches of the first switching network or the second switching network or both of them. Consequently, the central inductor *L_{DC}* may be coupled to the receiver resonant tank or between the receiver resonant tank and the energy buffer network. While the central inductor *L_{DC}* is coupled to the receiver resonant tank, the inductor charges either with a positive current or a negative current according to the polarity of the receiver resonant tank voltage.

The switch controlling circuit tracks the tuning condition of the receiver resonant circuit and respond by applying an adaptive time-delay that is synchronized with the start of either a positive cycle or negative cycle of the receiver resonant voltage. Then, after the elapsing of the time-delay, the switches of the first switching network or the second switching network are enabled to either couple the central inductor to the receiver resonant tank or the energy buffer network. The adaptive time-delay applied by the switch controlling circuit allow the synthesis of a variable reactance to be coupled in parallel with the WPT receiver tank. Consequently, the disclosed structure allow adaptive tuning of the receiver resonant circuit as well as energy rectification using a single central inductor L_{DC}.

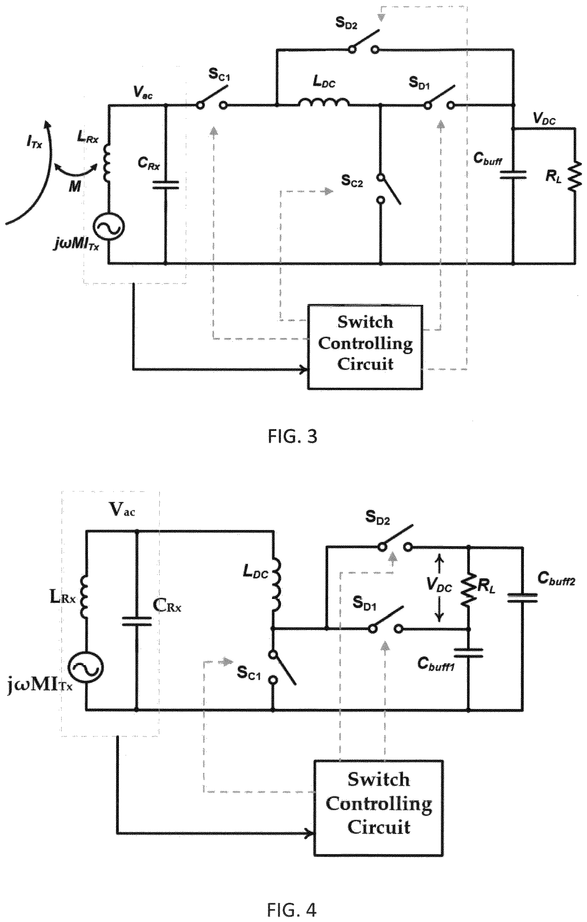

Figure 3 shows one embodiment of the invention including an apparatus for tuning and rectification and a WPT receiver. The topology of the WPT receiver comprises a receiving coil *L_{Rx}* compensated by one capacitor *C_{Rx}* in parallel, therefrom a parallel resonant tank is constituted. The tuning and rectification apparatus is connected in parallel with the receiver resonant tank.

In Figure 3, the tuning and rectification apparatus comprises a single inductor *L_{DC},* and four switches (S_{C1}, S_{C2}, S_{D1}, and S_{D2}) and an output capacitor *Cₒᵤₜ* representing an energy buffer. The switches are used to control the charging and discharging of the inductor *L_{DC}* by connecting the inductor *L_{DC}* either to the receiver resonant circuit or to the energy buffer *Cₒᵤₜ* or between both of them. Referring to the same figure, the apparatus includes a switch controlling circuit that senses one or more circuit parameters from the receiver resonant tank and produces the drive gating signals of the four switches.

In operation, the switch controlling circuit tracks the tuning condition of the receiver resonant tank, according to the sensed parameters, and then start the switching sequence after the elapsing of an adaptive time-delay. Then, switches S_{C1} and S_{C2} are engaged for a first time portion by enabling their drive gating signals, thereof, the inductor *L_{DC}* is coupled in parallel with the receiver resonant. During the said first time portion, the inductor charges with a current either going out or going in the receiver resonant circuit according to a positive cycle or negative cycle of the receiver resonant tank voltage. The first time portion may be a controlled time or uncontrolled. After that, during a second time portion, switch S_{C2} is opened and switch S_{D1} is closed to direct the energy to the energy buffer *Cₒᵤₜ.* The said second time portion the inductor is coupled between the receiver resonant tank and the energy buffer *Cₒᵤₜ,* wherein the second time portion may be controlled (or uncontrolled).
The implementation of switches (S_{C1}, S_{C2}, S_{D1}, and S_{D2}) may be realized by any semiconductor technology such as MOSFETs, IGBTs, or any other semiconductor technology that ensures a fast switching performance while the losses are kept low such that an optimum performance is guaranteed.

Figure 4 shows a tuner and rectifier apparatus according to another embodiment of the invention including a WPT receiver comprises a receiving coil *L_{Rx}* compensated by one capacitor *C_{Rx}* in parallel, therefrom a parallel resonant tank is constituted. The tuning and rectification apparatus comprises a single inductor *L_{DC},* and four switches (S_{C1}, S_{D1}, and S_{D2}) and two output capacitors *C_{buff1}* and *C_{buff2}* representing the energy buffer network. The switch S_{C1} controls the charging of the inductor *L_{DC}* from the receiver resonant tank while switches S_{D1} and S_{D2} controls the de-energization of inductor *L_{DC}* whereas the energy is rectified to one of the output capacitors. A switch controlling circuit that senses one or more circuit parameters from the receiver resonant tank and respond by selectively switch S_{C1}, S_{D1}, and S_{D2} accordingly through the drive gating signals.

The switch controlling circuit in Figure 4 tracks the tuning condition of the receiver resonant tank by sensing one or more parameters including a voltage or current or both of them. In order to adjust the reactive part synthesized by the circuit, the switch controlling circuit respond by generating an adaptive time delay in order to delay the engagement of the inductor *L_{DC}* to the receiver resonant circuit. It has been found that delaying the current passing out of the receiver resonant tank with respect to the receiver tank voltage synthesizes an inductive reactance loading to the receiver resonant tank. The synthesized inductive reactance is a function of the time-delay after which the inductor *L_{DC}* is engaged to the receiver resonant tank. In general, the switch controlling circuit adaptively track the tuning condition of the receiver resonant tank and respond by either increasing or decreasing the time-delay in order to synthesize a variable inductive reactance to retune the receiver tank.

In a positive cycle of the receiver resonant voltage, the switch controlling circuit delay the switching for an adaptive time-delay, then engage the inductor *L_{DC}* to the receiver tank by closing switch S_{C1} to charge the inductor during a first time portion. At the end of the first time portion which may be controlled (or uncontrolled), switch S_{C1} is opened and switch S_{D1} is closed for a second time portion, wherein the inductor *L_{DC}* is coupled between the receiver resonant tank and the first output capacitor *C_{buff1}* in order to rectify the energy to the output.

The same switching sequence is followed during the negative cycle of the receiver resonant voltage, after the elapsing of the adaptive time-delay, the inductor *L_{DC}* is engaged to the receiver resonant tank during a first time portion. The second time portion starts by opening switch S_{C1} and close switch S_{D2} to couple the inductor *L_{DC}* between the receiver resonant tank and the second output capacitor *C_{buff2}* to the rectify a second portion of the receiver tank energy. The final rectified output voltage may be the summation of the voltage of *C_{buff1}* and *C_{buff2}* wherein the load may be coupled between the two capacitors.

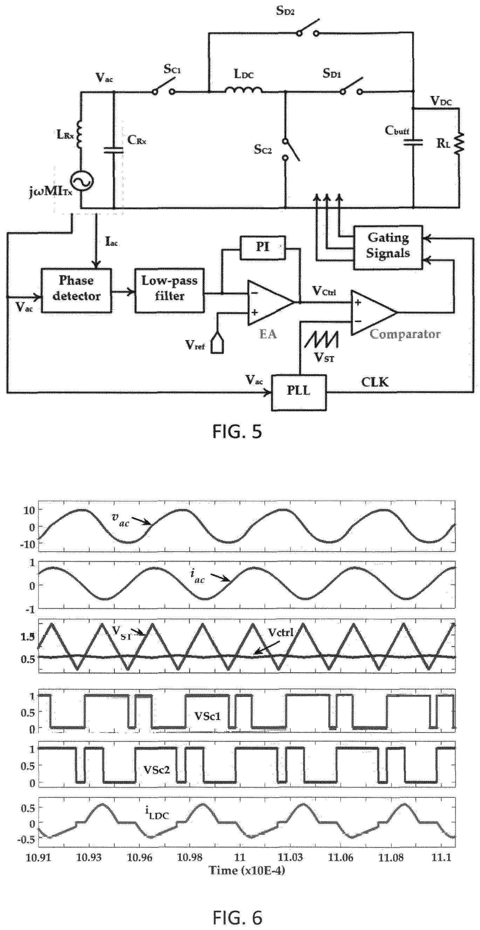

Figure 5 illustrates the tuner and rectifier apparatus in the embodiment of Figure 3 wherein the switch controlling circuit may be replaced by an embodiment shown in the figure. A possible MOSEFT based realization for switches S_{C1}, S_{C2}, S_{D1} and S_{D2} is also indicated in the schematic diagram. The switches realization shown in the figure may be considered as an exemplary embodiment, thereof the switches may be realized with a different technology without departing from the scope of the invention. The switch controlling circuit, in Figure 5, comprises a phase detector, low-pass filter, error amplifier (EA), phase locked loop (PLL), comparator and gating block. The control approach is designed based on sensing the receiver resonant tank voltage *v_{ac}* and the resonant current *i_{ac},* wherein the control loop ensures that *v_{ac}* lags the resonant current *i_{ac}* by 90°, thereof the receiver tank fully-tuned condition is reached. The output of the phase detector that represents the phase difference between *v_{ac}* and *i_{ac}* may be compared to a fixed reference voltage *V_{ref}* that corresponds to a phase lag of 90°. Then, the dc level coming from the error amplifier is compared with a sawtooth to produce the value of the time-delay a.

The full system including the invention embodiment and the exemplary control shown in Figure 5 is simulated to illustrate the operation. The simulation waveforms in Figure 6 shows the receiver resonant tank voltage *v_{ac},* the receiver resonant current *i_{ac},* the control output signal *V_{Ctrl},* the sawtooth signal *V_{ST},* the gating signals of S_{C1} and S_{C2}, and the inductor current *i_{LDC}.* According the aforementioned operation, the control output signal *V_{Ctrl},* is compared with the sawtooth signal *V_{ST}* to result in the correct delay-time value α corresponding a specific synthesizable inductance *L_{α}.* The said synthesizable inductance *L_{α}* is necessary for ensuring that the receiver resonant tank is fully-tuned.

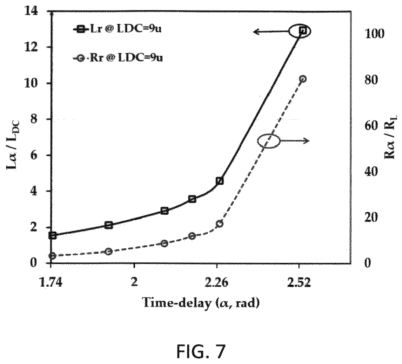

Figure 7 shows the ration between the equivalent synthesizable inductance *L_{α}* and the inductance *L_{DC}* (*L_{α}*/*L_{DC}*) versus the time-delay α in radian. It is clear that the equivalent synthesizable inductance *L_{α}* increases monotonically as the time-delay increases over a wide range extends between 2x to more than 12x of the actual inductance used *L_{DC}.* Moreover, the same figure shows the plot of the ratio between equivalent ac resistance *R_{α}* and the output load resistance *R_{L}* versus time-delay α in radian. It is shown that *R_{α}* also is a function of the time-delay α wherein the effect could be seen as a variation in the output power of the WPT receiver circuit, however if the first time portion for charging the inductor *L_{DC}* is controlled, the value of *R_{α}* could be adapted accordingly toward a constant value that corresponds to a constant output power.

## Claims

1. A tuner and rectifier circuit for wireless power transfer receiver, comprising:
- a receiver resonant tank comprising a receiving coil (L_{Rx}) linked by magnetic flux generated by an external transmitting coil, and one or more capacitive elements (C_{Rx}), wherein the receiving coil (L_{Rx}) and the one or more capacitive elements (C_{Rx}) are all connected in parallel; and
- a bridgeless tuner and rectifier circuit, comprising:
(a) an inductor (L_{DC}) configured to process electrical energy and coupled between a first switching network (S_{C1}, Sc2) and a second switching network (S_{D1}, S_{D2});
(b) the first switching network (S_{C1}, S_{C2}) being configured to exchange energy between the receiver resonant tank and the inductor (L_{DC}), and the second switching network (S_{D1}, S_{D2}) being configured to exchange energy between the inductor (L_{DC}) and an energy buffer network;
(c) the energy buffer network comprising one or more energy storage elements (C_{buff}, C_{buff1}, C_{buff2}), to supply a load coupled to terminals of the energy buffer network; and
(d) a switch controlling circuit to control the first switching network (S_{C1}, S_{C2}) and the second switching network (S_{D1}, S_{D2});
**characterized in that** the inductor (L_{DC}) is one single inductor (L_{DC}) and the switch controlling circuit is configured to:
(i) adaptively delay the switching of the first switching network (S_{C1}, S_{C2}) for an adaptive time-delay that is synchronized with the start of either a positive cycle or negative cycle of the receiver resonant tank voltage to synthesize a variable reactive inductance;
(ii) then activate the first switching network (S_{C1}, S_{C2}) to couple the receiver resonant tank to the single inductor (L_{DC}); and
(iii) then activate the second switching network (S_{D1}, S_{D2}) to couple the single inductor (L_{DC}) to the energy buffer network,
whereby the adaptive time-delay and the activation of the first and second switching networks (S_{C1}, S_{C2}; S_{D1}, S_{D2}) carries out adaptive tuning of the receiver resonant circuit as well as energy rectification using the one and the same single inductor (L_{DC}).

2. The tuner and rectifier circuit according to claim 1, wherein the switch controlling circuit is further configured to:
- sense one or more voltages or currents in the receiver resonant tank to track a fully-tuned state of the receiver resonant tank;
- wait for the elapsing of the adaptive time-delay after the start of the positive cycle of the receiver resonant tank voltage;
- close one or more switches of the first switching network (S_{C1}, S_{C2}) to electrically couple the single inductor (L_{DC}) in parallel with the receiver resonant tank during a first time portion of the positive cycle of the receiver resonant voltage, allowing the single inductor (L_{DC}) to charge with a positive current;
- maintain the one or more switches of the first switching network (S_{C1}, S_{C2}) closed and close one or more switches of the second switching network (S_{D1}, S_{D2}) during a second time portion of the positive cycle, allowing the single inductor (L_{DC}) to be coupled between the receiver resonant tank and the energy buffer network;
- wait for the elapsing of the same adaptive time-delay after the start of the negative cycle of the receiver resonant tank voltage;
- close one or more switches of the first switching network (S_{C1}, S_{C2}) to electrically couple the single inductor (L_{DC}) in parallel with the receiver resonant tank during a first time portion of the negative cycle of the receiver resonant voltage, allowing the single inductor (L_{DC}) to charge with a negative current; and
- maintain the one or more switches of the first switching network (S_{C1}, S_{C2}) closed and close one or more switches of the second switching network (S_{D1}, S_{D2}) during a second time portion of the negative cycle, allowing the single inductor (L_{DC}) to be coupled between the receiver resonant tank and the energy buffer network.

3. The tuner and rectifier circuit according to claim 1, wherein:
- the receiver resonant tank is coupled between a first node and a second node;
- the single inductor (L_{DC}) is coupled between a third node and a fourth node;
- the first switching network, comprises:
(a) a first switch (S_{C1}) coupled between the first node and the third node; and
(b) a second switch (S_{C2}) coupled between the fourth node and the second node,
- the second switching network comprises:
(a) a first switch (S_{D1}) coupled between the fourth node and a fifth node; and
(b) a second switch (S_{D2}) coupled between the third node and the fifth node,
- the one or more energy storage elements (C_{buff}) of the energy buffer network are coupled between the fifth node and the second node, and
and wherein the switch controlling circuit is configured to:
- track the fully-tuned state of the receiver resonant tank by generating an adaptive time period,
- maintain all switches opened during the said adaptive time period;
- close the first and second switches (S_{C1}, S_{C2}) of the first switching network allowing the single inductor (L_{DC}) to be coupled in parallel with the receiver resonant tank during a first time portion of the positive cycle of the receiver resonant voltage; and
- couple the single inductor (L_{DC}) between the receiver resonant tank and the energy buffer network by opening the second switch (S_{C2}) of the first switching network and closing the second switch (S_{D2}) of the second switching network during a second time portion of the positive cycle;
- close the first and second switches (S_{C1}, S_{C2}) of the first switching network after the same adaptive time period, allowing the single inductor (L_{DC}) to be coupled in parallel with the receiver resonant tank during a first time portion of the negative cycle of the receiver resonant voltage; and
- couple the single inductor (L_{DC}) to the energy buffer network by opening the first switch (S_{C1}) of the first switching network and closing the first switch (S_{D1}) of the second switching network during a second time portion of the said negative cycle.

4. The tuner and rectifier circuit according to claim 3, wherein the switch controlling circuit is further configured to:
- generate an adaptive time period synchronized with the starting of a positive or negative cycle of the receiver resonant voltage;
- couple the single inductor (L_{DC}) in parallel with the receiver resonant tank after the adaptive time period during the first time portion of the positive or negative cycle of the receiver resonant voltage; and
- couple the single inductor (L_{DC}) between the receiver resonant tank and the energy buffer network during the second time portion of the positive or negative cycle of the receiver resonant voltage.

5. The tuner and rectifier circuit according to claim 1, wherein:
- the receiver resonant tank is coupled between a first node and a second node,
- the single inductor (L_{DC}) is coupled between the first node and a third node,
- the first switching network, comprises:
(a) a switch (S_{C1}) coupled between the third node and the second node;
- the second switching network, comprises:
(a) a first switch (S_{D1}) coupled between the third node and fourth node; and
(b) a second switch (S_{D2}) coupled between the third node and fifth node,
- the energy buffer network, comprises:
(a) a first energy buffer (C_{buff1}) coupled between the fourth node and the second node;
(b) a second energy buffer (C_{buff2}) coupled between the second node and the fifth node,
and wherein the switch controlling circuit is configured to:
- track the fully-tuned state of the receiver resonant tank by adaptively generate an adaptive time period;
- maintain all switches (S_{C1}; S_{D1}, S_{D2}) of the first and second switching networks opened during the said adaptive time period;
- close the switch (S_{C1}) of the first switching network allowing the single inductor (L_{DC}) to be coupled in parallel with the receiver resonant tank during a first time portion of the positive cycle of the receiver resonant voltage;
- couple the single inductor (L_{DC}) between the receiver resonant tank and the first energy buffer (C_{buff1}) by opening the switch (S_{C1}) of the first switching network and closing the first switch (S_{D1}) of the second switching network during a second time portion of the said positive cycle;
- close the switch (S_{C1}) of the first switching network after the same adaptative time period, allowing the single inductor (L_{DC}) to be coupled in parallel with the receiver resonant tank during a first time portion of the negative cycle of the receiver resonant voltage; and
- couple the single inductor (L_{DC}) between the receiver resonant tank and the second energy buffer (C_{buff2}) by opening the switch (S_{C1}) of the first switching network and closing the second switch (S_{D2}) of the second switching network during a second time portion of the said negative cycle.

6. The tuner and rectifier circuit according to claim5, wherein the switch controlling circuit is further configured to:
- generate an adaptive time period synchronized with the starting of a positive or negative cycle of the receiver resonant voltage;
- couple the single inductor (L_{DC}) in parallel with the receiver resonant tank after the adaptive time period during a first time portion of the positive or negative cycle of the receiver resonant voltage; and
- couple the single inductor (L_{DC}) between the receiver resonant tank and one element of the energy buffer network during a second time portion of the positive or negative cycle of the receiver resonant voltage.

7. The tuner and rectifier circuit according to claim 1, wherein:
- the receiver resonant tank is coupled between a first node and a second node;
- the single inductor (L_{DC}) is coupled between a third node and a fourth node;
- the energy buffer network is coupled between a fifth node and a sixth node;
- the first switching network contains one or more switches and has two ports, with the first port of the first switching network being coupled between the first node and the second node, and the second port of the first switching network being coupled between the third node and the fourth node;
- the second switching network contains one or more switches and has two ports, with the first port of the second switching network being coupled between the third and the fourth nodes, and the second port of the second switching network being coupled between the fifth and the sixth nodes,
and wherein the switch controlling circuit is configured to:
- sense one or more parameters of the receiver resonant tank to track a tuning condition of the receiver resonant tank and apply an adaptive time-delay that is synchronized with the start of either a positive cycle or negative cycle of the receiver resonant voltage;
- then close one or more of the switches of the first switching network after the elapsing of the time-delay to couple the single inductor (L_{DC}) to the receiver resonant tank whereby the inductor charges either with a positive current or a negative current according to the polarity of the receiver resonant tank voltage; and
- then close one or more of the switches of the second switching network after the elapsing of the time-delay to couple the single inductor (L_{DC}) to the energy buffer network.

## Patentansprüche

1. Tuner- und Gleichrichterschaltung für einen drahtlosen Energieübertragungsempfänger, umfassend:
- einen Resonanztank des Empfängers, umfassend eine Empfangsspule (L_{RX}), die durch einen magnetischen Fluss angeschlossen ist, der von einer externen Übertragungsspule erzeugt wird, und eines oder mehrere kapazitive Elemente (C_{RX}), wobei die Empfangsspule (L_{RX}) und das eine oder die mehreren kapazitiven Elemente (C_{RX}) alle parallel geschaltet sind; und
- eine brückenlose Tuner- und Gleichrichterschaltung, umfassend:
(a) eine Induktivität (L_{DC}), die zum Verarbeiten elektrischer Energie konfiguriert ist und zwischen einem ersten Schaltnetz (S_{C1}, S_{C2}) und einem zweiten Schaltnetz (S_{D1}, S_{D2}) gekoppelt ist;
(b) das erste Schaltnetz (S_{C1}, S_{C2}), das konfiguriert sind, um Energie zwischen dem Resonanztank des Empfängers und der Induktivität (L_{DC}) auszutauschen, wobei das zweite Schaltnetz (S_{D1}, S_{D2}) konfiguriert ist, um Energie zwischen der Induktivität (Ldc) und einem Energiepuffernetz auszutauschen;
(c) das Energiepuffernetz, umfassend das eine oder mehrere Energiespeicherelemente (C_{buff}, C_{buff1}, C_{buff2}) zum Abgeben einer Last, die mit den Anschlüssen des Energiepuffernetzes gekoppelt ist; und
(d) eine Schaltersteuerschaltung zum Steuern des ersten Schaltnetzes (S_{C1}, S_{C2}) und des zweiten Schaltnetzes (S_{D1}, S_{D2});
**dadurch gekennzeichnet, dass** die Induktivität (Ldc) eine einzelne Induktivität (L_{DC}) ist und die Schaltersteuerschaltung konfiguriert ist zum:
(i) adaptiven Verzögern des Umschaltens des ersten Schaltnetzes (S_{C1}, S_{C2}) für eine adaptive Zeitverzögerung, die entweder mit dem Beginn eines positiven Zyklus oder eines negativen Zyklus der Resonanztankspannung des Empfängers synchronisiert ist, um eine variable Blindinduktivität zu synthetisieren;
(ii) dann Aktivieren des ersten Schaltnetzes (S_{C1}, S_{C2}), um den Resonanztank des Empfängers mit der einzelnen Induktivität (L_{DC}) zu koppeln; und
(iii) dann Aktivieren des zweiten Schaltnetzes (S_{d1}, S_{d2}), um die einzelne Induktivität (L_{DC}) mit dem Energiepuffernetz zu koppeln,
wobei die adaptive Zeitverzögerung und die Aktivierung des ersten und zweiten Schaltnetzes (S_{C1}, S_{C2}; S_{D1}, S_{D2}) ein adaptives Tuning der Resonanzschaltung des Empfängers sowie eine Energiegleichrichtung unter Verwendung ein und derselben einzelnen Induktivität (L_{DC}) ausführt.

2. Tuner- und Gleichrichterschaltung nach Anspruch 1, wobei die Schaltsteuerschaltung ferner konfiguriert ist zum:
- Erfassen einer oder mehrerer Spannungen oder Ströme im Resonanztank des Empfängers, um einen vollständig abgestimmten Zustand des Resonanztanks des Empfängers nachzuverfolgen;
- Warten auf das Ablaufen der adaptiven Zeitverzögerung nach dem Start des positiven Zyklus der Resonanztankspannung des Empfängers;
- Schließen eines oder mehrerer Schalter des ersten Schaltnetzes (S_{C1}, S_{C2}), um die einzelne Induktivität (L_{DC}) parallel zum Resonanztank des Empfängers während eines ersten Zeitabschnitts des positiven Zyklus der Resonanzspannung des Empfängers elektrisch zu koppeln, wodurch die einzelne Induktivität (L_{DC}) mit einem positiven Strom aufgeladen werden kann;
- Geschlossenhalten des einen oder der mehreren Schalter des ersten Schaltnetzes (S_{C1}, S_{C2}) und Schließen des einen oder der mehreren Schalter des zweiten Schaltnetzes (S_{D1}, S_{D2}) während eines zweiten Zeitabschnitts des positiven Zyklus, wodurch die einzelne Induktivität (L_{DC}) zwischen dem Resonanztank des Empfängers und dem Energiepuffernetz gekoppelt werden kann;
- Warten auf das Ablaufen derselben adaptiven Zeitverzögerung nach dem Beginn des negativen Zyklus der Resonanztankspannung des Empfängers;
- Schließen eines oder mehrerer der Schalter des ersten Schaltnetzes (S_{C1}, S_{C2}), um die einzelne Induktivität (L_{DC}) parallel zum Resonanztank des Empfängers während eines ersten Zeitabschnitts des negativen Zyklus der Resonanzspannung des Empfängers elektrisch zu koppeln, Zulassen, dass die einzelne Induktivität (L_{DC}) mit einem negativen Strom lädt; und
- Geschlossenhalten des einen oder der mehreren Schalter des ersten Schaltnetzes (S_{C1}, S_{C2}) und Schließen des einen oder der mehreren Schalter des Schaltnetzes (S_{D1}, S_{D2}) während eines zweiten Zeitabschnitts des negativen Zyklus, Zulassen des Koppelns der einzelnen Induktivität (L_{DC}) zwischen dem Resonanztank des Empfängers und dem Energiepuffernetz.

3. Tuner- und Gleichrichterschaltung nach Anspruch 1, wobei:
- der Resonanztank des Empfängers zwischen einem ersten Knoten und einem zweiten Knoten gekoppelt ist;
- die einzelne Induktivität (L_{DC}) zwischen einem dritten Knoten und einem vierten Knoten gekoppelt ist;
- das erste Schaltnetz umfasst:
(a) einen ersten Schalter (S_{C1}), der zwischen dem ersten Knoten und dem dritten Knoten gekoppelt ist; und
(b) einen zweiten Schalter (S_{C2}), der zwischen dem vierten Knoten und dem zweiten Knoten gekoppelt ist,
- das zweite Schaltnetz umfasst:
(a) einen ersten Schalter (S_{D1}), der zwischen dem vierten Knoten und einem fünften Knoten gekoppelt ist; und
(b) einen zweiten Schalter (S_{D2}), der zwischen dem dritten Knoten und dem fünften Knoten gekoppelt ist,
- das eine oder die mehreren Energiespeicherelemente (C_{buff}) des Energiepuffernetzes zwischen dem fünften Knoten und dem zweiten Knoten gekoppelt sind und
und wobei die Schaltersteuerschaltung konfiguriert ist zum:
- Verfolgen des vollständig abgestimmten Zustands des Resonanztanks des Empfängers durch Erzeugen eines Anpassungszeitraums,
- Geöffnethalten aller Schalter während des Anpassungszeitraums;
- Schließen des ersten und zweiten Schalters (S_{C1}, S_{C2}) des ersten Schaltnetzes, damit die einzelne Induktivität (L_{DC}) während eines ersten Zeitabschnitts des positiven Zyklus der Resonanzspannung des Empfängers parallel mit dem Resonanztank des Empfängers gekoppelt werden kann; und
- Koppeln der einzelnen Induktivität (L_{DC}) zwischen dem Resonanztank des Empfängers und dem Energiepuffernetz durch Öffnen des zweiten Schalters (S_{C2}) des ersten Schaltnetzes und Schließen des zweiten Schalters (S_{D2}) des zweiten Schaltnetzes während eines zweiten Zeitabschnitts des positiven Zyklus;
- Schließen des ersten und zweiten Schalters (S_{C1}, S_{C2}) des ersten Schaltnetzes nach dem gleichen adaptiven Zeitraum, Zulassen, dass die einzelne Induktivität (L_{DC}) parallel zum Resonanztank des Empfängers während eines ersten Zeitabschnitts des negativen Zyklus der Resonanzspannung des Empfängers elektrisch gekoppelt werden kann; und
- Koppeln der einzelnen Induktivität (L_{DC}) mit dem Energiepuffernetz durch Öffnen des zweiten Schalters (S_{C1}) des ersten Schaltnetzes und Schließen des ersten Schalters (S_{D1}) des zweiten Schaltnetzes während eines zweiten Zeitabschnitts des negativen Zyklus.

4. Tuner- und Gleichrichterschaltung nach Anspruch 3, wobei die Schaltsteuerschaltung ferner konfiguriert ist zum:
- Erzeugen eines adaptiven Zeitraums, der mit dem Beginn eines positiven oder negativen Zyklus der Resonanzspannung des Empfängers synchronisiert ist;
- Koppeln der einzelnen Induktivität (L_{DC}) parallel zum Resonanztank des Empfängers nach dem Anpassungszeitraum während des ersten Zeitabschnitts des positiven oder negativen Zyklus der Resonanzspannung des Empfängers; und
- Koppeln der einzelnen Induktivität (L_{DC}) zwischen dem Resonanztank des Empfängers und dem Energiepuffernetz während des zweiten Zeitabschnitts des positiven oder negativen Zyklus der Resonanzspannung des Empfängers.

5. Tuner- und Gleichrichterschaltung nach Anspruch 1, wobei:
- der Resonanztank des Empfängers zwischen einem ersten Knoten und einem zweiten Knoten gekoppelt ist,
- die einzelne Induktivität (L_{DC}) zwischen dem ersten Knoten und einem dritten Knoten gekoppelt ist,
- das erste Schaltnetz umfasst:
(a) einen Schalter (S_{C1}), der zwischen dem dritten Knoten und dem zweiten Knoten gekoppelt ist;
- das zweite Schaltnetz umfasst:
(a) einen ersten Schalter (S_{D1}), der zwischen dem dritten Knoten und dem vierten Knoten gekoppelt ist; und
(b) einen zweiten Schalter (S_{D2}), der zwischen dem dritten Knoten und dem fünften Knoten gekoppelt ist,
- das Energiepuffernetz umfasst:
(a) einen ersten Energiepuffer (C_{buff1}), der zwischen dem vierten Knoten und dem zweiten Knoten gekoppelt ist;
(b) einen zweiten Energiepuffer (C_{buff2}), der zwischen dem zweiten Knoten
und dem fünften Knoten gekoppelt ist,
und wobei die Schaltersteuerschaltung konfiguriert ist zum:
- Verfolgen des vollständig abgestimmten Zustands des Resonanztanks des Empfängers durch adaptives Erzeugen eines adaptiven Zeitraums;
- Offenhalten aller Schalter (S_{C1}; S_{D1}, S_{D1}) des ersten und des zweiten Schaltnetzes, die während des Anpassungszeitraums geöffnet wurden;
- Schließen des Schalters (S_{C1}) des ersten Schaltnetzes, damit die einzelne Induktivität (L_{DC}) während eines ersten Zeitabschnitts des positiven Zyklus der Resonanzspannung des Empfängers parallel mit dem Resonanztank des Empfängers gekoppelt werden kann;
- Koppeln der einzelnen Induktivität (L_{DC}) zwischen dem Resonanztank des Empfängers und dem Energiepuffer (C_{buff1}) durch Öffnen des Schalters (S_{C1}) des ersten Schaltnetzes und Schließen des ersten Schalters (S_{D1}) des zweiten Schaltnetzes während eines zweiten Zeitabschnitts des positiven Zyklus;
- Schließen des Schalters (S_{C1}) des ersten Schaltnetzes nach dem gleichen adaptiven Zeitraum, Zulassen, dass die einzelne Induktivität (L_{DC}) parallel zum Resonanztank des Empfängers während eines ersten Zeitabschnitts des negativen Zyklus der Resonanzspannung des Empfängers elektrisch gekoppelt werden kann; und
- Koppeln der einzelnen Induktivität (L_{DC}) zwischen dem Resonanztank des Empfängers und dem zweiten Energiepuffer (C_{buff2}) durch Öffnen des Schalters (S_{C1}) des ersten Schaltnetzes und Schließen des zweiten Schalters (S_{D2}) des zweiten Schaltnetzes während eines zweiten Zeitabschnitts des negativen Zyklus.

6. Tuner- und Gleichrichterschaltung nach Anspruch 5, wobei die Schaltsteuerschaltung ferner konfiguriert ist zum:
- Erzeugen eines adaptiven Zeitraums, der mit dem Beginn eines positiven oder negativen Zyklus der Resonanzspannung des Empfängers synchronisiert ist;
- Koppeln der einzelnen Induktivität (L_{DC}) parallel zum Resonanztank des Empfängers nach dem adaptiven Zeitraum während eines ersten Zeitabschnitts des positiven oder negativen Zyklus der Resonanzspannung des Empfängers; und
- Koppeln der einzelnen Induktivität (L_{DC}) zwischen dem Resonanztank des Empfängers und dem einen Element des Energiepuffernetzes während eines zweiten Zeitabschnitts des positiven oder negativen Zyklus der Resonanzspannung des Empfängers.

7. Tuner- und Gleichrichterschaltung nach Anspruch 1, wobei:
- der Resonanztank des Empfängers zwischen einem ersten Knoten und einem zweiten Knoten gekoppelt ist;
- die einzelne Induktivität (L_{DC}) zwischen einem dritten Knoten und einem vierten Knoten gekoppelt ist;
- das Energiepuffernetz zwischen einem fünften Knoten und einem sechsten Knoten gekoppelt ist;
- das erste Schaltnetz einen oder mehrere Schalter enthält und zwei Anschlüsse aufweist, wobei der erste Anschluss des ersten Schaltnetzes zwischen dem ersten Knoten und dem zweiten Knoten gekoppelt ist und der zweite Anschluss des ersten Schaltnetzes zwischen dem dritten Knoten und dem vierten Knoten gekoppelt ist;
- das zweite Schaltnetz einen oder mehrere Schalter und zwei Anschlüsse aufweist, wobei der erste Anschluss des zweiten Schaltnetzes zwischen dem dritten und dem vierten Knoten gekoppelt ist und der zweite Anschluss des zweiten Schaltnetzes zwischen dem fünften und dem sechsten Knoten gekoppelt ist,
und wobei die Schaltersteuerschaltung konfiguriert ist zum:
- Erfassen eines oder mehrerer Parameter des Resonanztanks des Empfängers, um einen Tuning-Zustand des Resonanztank des Empfängers nachzuverfolgen und eine adaptive Zeitverzögerung anzuwenden, die mit dem Beginn eines positiven Zyklus oder eines negativen Zyklus der Resonanzspannung des Empfängers synchronisiert ist;
- dann Schließen des einen oder der mehreren Schalter des ersten Schaltnetzes nach Ablauf der Zeitverzögerung, um die einzelne Induktivität (L_{DC}) mit dem Resonanztank des Empfängers zu koppeln, wobei sich die Induktivität je nach Polarität der Resonanztankspannung des Empfängers entweder mit einem positiven oder einem negativen Strom auflädt; und
- dann Schließen eines oder mehrerer Schalter des zweiten Schaltnetzes nach Ablauf der Zeitverzögerung, um die einzelne Induktivität (L_{DC}) mit dem Energiepuffernetz zu koppeln.

## Revendications

1. Circuit syntoniseur et redresseur pour récepteur de transfert de puissance sans fil, comprenant :
- une cuve de résonance de récepteur comprenant une bobine de réception (L_{RX}) reliée par un flux magnétique généré par une bobine de transmission externe, et un ou plusieurs éléments capacitifs (C_{RX}), dans lequel la bobine de réception (L_{RX}) et l'un ou plusieurs éléments capacitifs (C_{RX}) sont tous raccordés en parallèle ; et
- un circuit syntoniseur et redresseur sans pont, comprenant :
(a) un inducteur (L_{DC}) configuré pour traiter l'énergie électrique et couplé entre un premier réseau de commutation (S_{C1}, S_{C2}) et un deuxième réseau de commutation (S_{D1}, S_{D2}) ;
(b) le premier réseau de commutation (S_{C1}, S_{C2}) étant configuré pour échanger de l'énergie entre la cuve de résonance de récepteur et l'inducteur (L_{DC}) et le deuxième réseau de commutation (S_{D1}, S_{D2}) étant configuré pour échanger de l'énergie entre l'inducteur (L_{DC}) et un réseau de tampon d'énergie ;
(c) le réseau de tampon d'énergie comprenant un ou plusieurs éléments de stockage d'énergie (Cₜₐₘₚ, Cₜₐₘₚ₁, Cₜₐₘₚ₂), pour alimenter une charge couplée aux bornes du réseau de tampon d'énergie ; et
(d) un circuit de commande de commutateur pour commander le premier réseau de commutation (S_{C1}, S_{C2}) et le deuxième réseau de commutation (S_{D1}, S_{D2}) ;
**caractérisé en ce que** l'inducteur (L_{DC}) est un inducteur unique (Loc) et le circuit de commande de commutateur est configuré pour :
(i) retarder de manière adaptative la commutation du premier réseau de commutation (S_{C1}, S_{C2}) pour une temporisation adaptative synchronisée avec le début d'un cycle positif ou d'un cycle négatif de la tension de la cuve de résonance de récepteur pour synthétiser une inductance réactive variable ;
(ii) puis activer le premier réseau de commutation (S_{C1}, S_{C2}) pour coupler la cuve de résonance de récepteur à l'inducteur unique (L_{DC}) ; et
(iii) puis activer le deuxième réseau de commutation (S_{d1}, S_{d2}) pour coupler l'inducteur unique (L_{DC}) au réseau de tampon d'énergie,
moyennant quoi la temporisation adaptative et l'activation des premier et deuxième réseaux de commutation (S_{C1}, S_{C2} ; S_{D1}, S_{D2}) effectuent la syntonisation adaptative du circuit de résonance de récepteur ainsi que le redressement de l'énergie en utilisant le même inducteur unique (L_{DC}).

2. Circuit syntoniseur et redresseur selon la revendication 1, dans lequel le circuit de commande de commutateur est en outre configuré pour :
- détecter une ou plusieurs tensions ou courants dans la cuve de résonance de récepteur pour suivre un état entièrement syntonisé de la cuve de résonance de récepteur ;
- attendre l'écoulement de la temporisation adaptative après le début du cycle positif de la tension de la cuve de résonance de récepteur ;
- fermer un ou plusieurs commutateurs du premier réseau de commutation (S_{C1}, S_{C2}) pour coupler électriquement l'inducteur unique (L_{DC}) en parallèle avec la cuve de résonance de récepteur pendant une première partie de temps du cycle positif de la tension de résonance du récepteur, permettant à l'inducteur unique (L_{DC}) de charger avec un courant positif ;
- maintenir l'un ou plusieurs commutateurs du premier réseau de commutation (S_{C1}, S_{C2}) fermé et fermer un ou plusieurs commutateurs du deuxième réseau de commutation (S_{D1}, S_{D2}) pendant une deuxième partie de temps du cycle positif, permettant à l'inducteur unique (L_{DC}) d'être couplé entre la cuve de résonance de récepteur et le réseau de tampon d'énergie ;
- attendre l'écoulement de la même temporisation adaptative après le début du cycle négatif de la tension de la cuve de résonance de récepteur ;
- fermer un ou plusieurs commutateurs du premier réseau de commutation (S_{C1}, S_{C2}) pour coupler électriquement l'inducteur unique (L_{DC}) en parallèle avec la cuve de résonance de récepteur pendant une première partie de temps du cycle négatif de la tension de résonance de récepteur, permettant à l'inducteur unique (L_{DC}) de charger avec un courant négatif ; et
- maintenir l'un ou plusieurs commutateurs du premier réseau de commutation (S_{C1}, S_{C2}) fermé et fermer un ou plusieurs commutateurs du deuxième réseau de commutation (S_{D1}, S_{D2}) pendant une deuxième partie de temps du cycle négatif, permettant à l'inducteur unique (L_{DC}) d'être couplé entre la cuve de résonance de récepteur et le réseau de tampon d'énergie.

3. Circuit syntoniseur et redresseur selon la revendication 1, dans lequel :
- la cuve de résonance de récepteur est couplée entre un premier nœud et un deuxième noeud ;
- l'inducteur unique (L_{DC}) est couplé entre un troisième nœud et un quatrième nœud ;
- le premier réseau de commutation, comprend
(a) un premier commutateur (S_{C1}) couplé entre le premier nœud et le troisième nœud ; et
(b) un deuxième commutateur (S_{C2}) couplé entre le quatrième nœud et le deuxième nœud,
- le deuxième réseau de commutation comprend :
(a) un premier commutateur (S_{D1}) couplé entre le quatrième nœud et un cinquième nœud ; et
(b) un deuxième commutateur (S_{D2}) couplé entre le troisième nœud et le cinquième nœud,
- l'un ou plusieurs éléments de stockage d'énergie (Cₜₐₘₚ) du réseau de tampon d'énergie sont couplés entre le cinquième nœud et le deuxième nœud, et
et dans lequel le circuit de commande de commutateur est configuré pour :
- suivre l'état entièrement syntonisé de la cuve de résonance de récepteur en générant une période de temps adaptative,
- maintenir tous les commutateurs ouverts pendant ladite période de temps adaptative ;
- fermer les premier et deuxième commutateurs (S_{C1}, S_{C2}) du premier réseau de commutation permettant au seul inducteur (L_{DC}) d'être couplé en parallèle avec la cuve de résonance de récepteur pendant une première partie de temps du cycle positif de la tension de résonance de récepteur ; et
- coupler l'inducteur unique (L_{DC}) entre la cuve de résonance de récepteur et le réseau de tampon d'énergie en ouvrant le deuxième commutateur (S_{C2}) du premier réseau de commutation et en fermant le deuxième commutateur (S_{D2}) du deuxième réseau de commutation pendant une deuxième partie de temps du cycle positif ;
- fermer les premier et deuxième commutateurs (S_{C1}, S_{C2}) du premier réseau de commutation après la même période de temps adaptative, permettant à l'inducteur unique (L_{DC}) d'être couplé en parallèle avec la cuve de résonance de récepteur pendant une première partie de temps du cycle négatif de la tension de résonance de récepteur ; et
- coupler l'inducteur unique (L_{DC}) au réseau de tampon d'énergie en ouvrant le premier commutateur (S_{C1}) du premier réseau de commutation et en fermant le premier commutateur (S_{D1}) du deuxième réseau de commutation pendant une deuxième partie de temps dudit cycle négatif,

4. Circuit syntoniseur et redresseur selon la revendication 3, dans lequel le circuit de commande de commutateur est en outre configuré pour :
- générer une période de temps adaptative synchronisée avec le début d'un cycle positif ou négatif de la tension de résonance de récepteur ;
- coupler l'inducteur unique (L_{DC}) en parallèle avec la cuve de résonance de récepteur après la période de temps adaptative pendant la première partie de temps du cycle positif ou négatif de la tension de résonance du récepteur ; et
- coupler l'inducteur unique (L_{DC}) entre la cuve de résonance de récepteur et le réseau de tampon d'énergie pendant la deuxième partie de temps du cycle positif ou négatif de la tension de résonance de récepteur.

5. Circuit syntoniseur et redresseur selon la revendication 1, dans lequel :
- la cuve de résonance de récepteur est couplée entre un premier noeud et un deuxième nœud,
- l'inducteur unique (L_{DC}) est couplé entre le premier nœud et un troisième nœud,
- le premier réseau de commutation, comprend :
(a) un commutateur (S_{C1}) couplé entre le troisième nœud et le deuxième nœud ;
- le deuxième réseau de commutation, comprend :
(a) un premier commutateur (S_{D1}) couplé entre le troisième nœud et le quatrième nœud ; et
(b) un deuxième commutateur (S_{D2}) couplé entre le troisième nœud et le cinquième nœud,
- le réseau de tampon d'énergie, comprend :
(a) un premier tampon d'énergie (Cₜₐₘₚ₁) couplé entre le quatrième nœud et le deuxième nœud ;
(b) un deuxième tampon d'énergie (Cₜₐₘₚ₂) couplé entre le deuxième nœud et le cinquième nœud,
et dans lequel le circuit de commande de commutateur est configuré pour :
- suivre l'état entièrement syntonisé de la cuve de résonance de récepteur en générant de manière adaptative une période de temps adaptative ;
- maintenir tous les commutateurs (S_{C1} ; S_{D1}, S_{D1}) des premier et deuxième réseaux de commutation ouverts pendant ladite période de temps adaptative ;
- fermer le commutateur (S_{C1}) du premier réseau de commutation permettant à l'inducteur unique (L_{DC}) d'être couplé en parallèle avec la cuve de résonance de récepteur pendant une première partie de temps du cycle positif de la tension de résonance de récepteur;
- coupler l'inducteur unique (L_{DC}) entre la cuve de résonance de récepteur et le premier tampon d'énergie (Cₜₐₘₚ₁) en ouvrant le commutateur (S_{C1}) du premier réseau de commutation et en fermant le premier commutateur (S_{D1}) du deuxième réseau de commutation pendant une deuxième partie de temps dudit cycle positif ;
- fermer le commutateur (S_{C1}) du premier réseau de commutation après la même période de temps adaptative, permettant à l'inducteur unique (L_{DC}) d'être couplé en parallèle avec la cuve de résonance de récepteur pendant une première partie de temps du cycle négatif de la tension de résonance de récepteur ; et
- coupler l'inducteur unique (L_{DC}) entre la cuve de résonance de récepteur et le deuxième tampon d'énergie (Cₜₐₘₚ₂) en ouvrant le commutateur (S_{C1}) du premier réseau de commutation et en fermant le deuxième commutateur (S_{D2}) du deuxième réseau de commutation pendant une deuxième partie de temps dudit cycle négatif.

6. Circuit syntoniseur et redresseur selon la revendication 5, dans lequel le circuit de commande de commutateur est en outre configuré pour :
- générer une période de temps adaptative synchronisée avec le début d'un cycle positif ou négatif de la tension de résonance de récepteur ;
- coupler l'inducteur unique (L_{DC}) en parallèle avec la cuve de résonance de récepteur après la période de temps adaptative pendant une première partie de temps du cycle positif ou négatif de la tension de résonance de récepteur ; et
- coupler l'inducteur unique (L_{DC}) entre la cuve de résonance de récepteur et un élément du réseau de tampon d'énergie pendant une deuxième partie de temps du cycle positif ou négatif de la tension de résonance du récepteur.

7. Circuit syntoniseur et redresseur selon la revendication 1, dans lequel :
- la cuve de résonance de récepteur est couplée entre un premier nœud et un deuxième noeud ;
- l'inducteur unique (L_{DC}) est couplé entre un troisième nœud et un quatrième noeud ;
- le réseau de tampon d'énergie est couplé entre un cinquième nœud et un sixième nœud ;
- le premier réseau de commutation contient un ou plusieurs commutateurs et a deux ports, avec le premier port du premier réseau de commutation étant couplé entre le premier nœud et le deuxième nœud, et le deuxième port du premier réseau de commutation étant couplé entre le troisième nœud et le quatrième nœud ;
- le deuxième réseau de commutation contient un ou plusieurs commutateurs et a deux ports, avec le premier port du deuxième réseau de commutation étant couplé entre les troisième et quatrième nœuds, et le deuxième port du deuxième réseau de commutation étant couplé entre les cinquième et sixième nœuds,
et dans lequel le circuit de commande de commutateur est configuré pour ;
- détecter un ou plusieurs paramètres de la cuve de résonance de récepteur pour suivre une condition de syntonisation de la cuve de résonance de récepteur et appliquer une temporisation adaptative qui est synchronisée avec le début d'un cycle positif ou négatif de la tension de résonance de récepteur ;
- puis fermer un ou plusieurs des commutateurs du premier réseau de commutation après l'écoulement de la temporisation pour coupler l'inducteur unique (L_{DC}) à la cuve de résonance de récepteur moyennant quoi l'inducteur se charge avec un courant positif ou un courant négatif en fonction de la polarité de la tension de la cuve de résonance de récepteur ; et
- puis fermer un ou plusieurs des commutateurs du deuxième réseau de commutation après l'écoulement de la temporisation pour coupler l'inducteur unique (L_{DC}) au réseau de tampon d'énergie.
